# EUROPEAN PATENT SPECIFICATION

(11) **EP 1 555 692 B1**
(45) Date of publication and mention of the grant of the patent: **23.01.2019**
(21) Application number: 04258189.2
(22) Date of filing: 29.12.2004
(51) Int. Cl.: H01L 23/40, H01L 25/11

(54) **Fixing device for electronic components**
Befestigungsvorrichtung für elektronische Bauelemente
Dispositif de fixation pour composants électroniques

(30) Priority: 25.12.2003 JP 2003431619
(43) Date of publication of application: 20.07.2005
(73) Proprietor: AISIN SEIKI KABUSHIKI KAISHA, Kariya-shi, Aichi-ken 448-8650 (JP); Matsuo Industries Inc., Obu-shi, Aichi-ken, 474-0001 (JP)
(72) Inventor: Sugiyama, Masanori, Kariya-shi, Aichi-ken 448-8650 (JP); Okumura, Masao, Obu-shi, Aichi-Ken (JP)
(74) Representative: Serjeants LLP

(56) References cited:
- EP-A2- 1 047 293
- DE-A1- 3 331 207
- DE-A1- 3 440 334
- DE-A1- 4 141 650
- FR-A3- 2 654 156
- JP-A- 9 153 691
- JP-A- H11 298 177
- US-B1- 6 587 344

## Description

### FIELD OF THE INVENTION

The present invention relates to a fixing device, More particularly, the present invention pertains to a fixing device for electronic components.

### BACKGROUND

Known fixing device for electronic components are described in WO 00/65891, JP11(1999)-297910A, JP06(1994)21252Y2, JP09(1997)321194A, JP10(1998)-107189A, and WO 92/10925. The fixing devices described in WO. 00/65891, JP11(1999)-297910A, JP06(1994)21252Y2, JP09(1997)321194A, JP10(1998)-107189A, and WO 92/10925 fix the electronic components by means of biasing force of biasing members.

With the construction of the fixing devices described in WO 00/65891, JP11(1999)-297910A, JP09(1997)321194A, and WO 92/10925, heat radiation performance is declined because U shaped biasing members restrict arrangement of heat radiation members when plural heat radiation members are connected to radiate the heat. Further, with the construction of the above-mentioned known fixing devices, if the position of the electronic components in the lateral direction is different from the clipping direction of the electronic components, this cannot be determined.

Further, with the construction of known fixing devices described in WO 00/65891, JP11(1999)-297910A, JP06(1994)21252Y2, JP09(1997)321194A, JP10(1998)-107189A, and WO 92/10925, space efficiency is declined because sufficient clearance is required to be provided between the biasing members and the electronic components in order to prevent short circuit when fixing the electronic components which are not fully molded and a heat radiation fin made from metal is exposed outside.

With the construction of known fixing devices described in JP11(1999)-297910A, JP06(1994)21252Y2, JP09(1997)321194A, JP10(1998)-107189A, and WO 92/10925, the degree of freedom for manufacturing is declined because, for example, a manufacturing process for mounting an entire assembly on a board after assembling the electronic components at another production line is not possible. JP-09-153691 and DE-A1-4141650 describe further examples of fixing devices for electronic components and both fixing devices employ a U-shaped biasing member to fix the electronic components in position. A yet further example of a fixing device is described in JP-H11-298177 A.

A need thus exists for a fixing device, which securely determines the
position of electronic components while restraining short circuit of the electronic components without reducing the degree of freedom of the manufacturing process.

### SUMMARY OF THE INVENTION

In light of the foregoing, the present invention provides a fixing device according to claim 1. Preferred embodiments of the invention are defined in the dependent claims.

According to the present invention, the position of an electronic component is determined by means of an insulation member at an accommodation portion. The position of the electronic component is determined between a heat radiation member and the insulation member relative to the heat radiation member by means of a position determining means. The electronic component is supported by clipping and holding the heat radiation member and the insulation member by a biasing member. Accordingly, the position of the electronic component is more securely determined.

Because the electronic component is sandwiched between the heat radiation member and the insulation member, the electronic component is covered with insulation material to restrain exposure to the outside. Thus, the risk of short circuit of the electronic component is reduced. Further, because the heat radiation member and the insulation member are clipped and held by the biasing member along with the electronic component positioned between the heat radiation member and the insulation member, the heat radiation member, the insulation member, and the electronic component are unitarily assembled. Accordingly, degree of freedom for the manufacturing process is raised because, for example, the assembly of the heat radiation member, the insulation member, and the electronic component assembled at another production line can be conveyed and mounted on a board.

### BRIEF DESCRIPTION OF THE DRAWINGS

The foregoing and additional features and characteristics of the present invention will become more apparent from the following detailed description considered with reference to the accompanying drawings, wherein:
Fig. 1 shows a perspective view of a first embodiment of the present invention.
Fig. 2 shows a partial cross-sectional view of the first embodiment of the present invention.
Fig. 3 shows an exploded view of the first embodiment of the present invention.
Fig. 4 is a partial cross-sectional view showing an assembling process of the first embodiment of the present invention.
Fig. 5 is a perspective view of a second embodiment of the present invention.
Fig. 6 is a partial cross-sectional view of the second embodiment of the present invention.

### DETAILED DESCRIPTION

Embodiments of the present invention will be explained with reference to illustrations of drawing figures as follows,

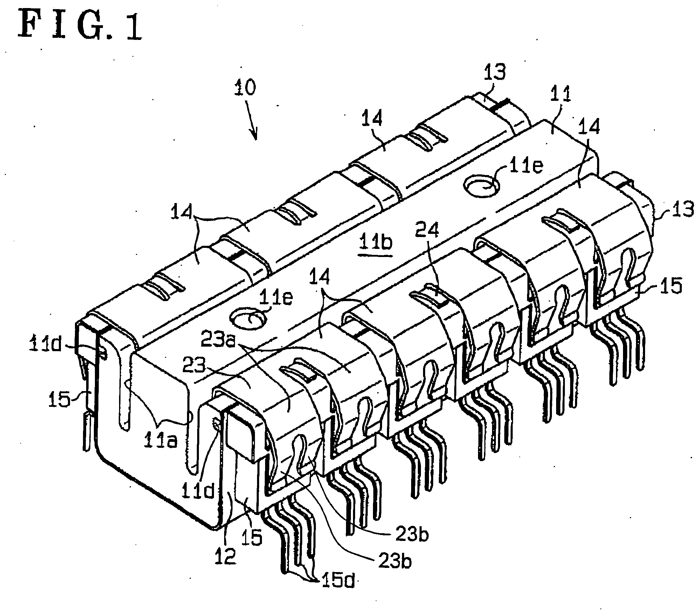

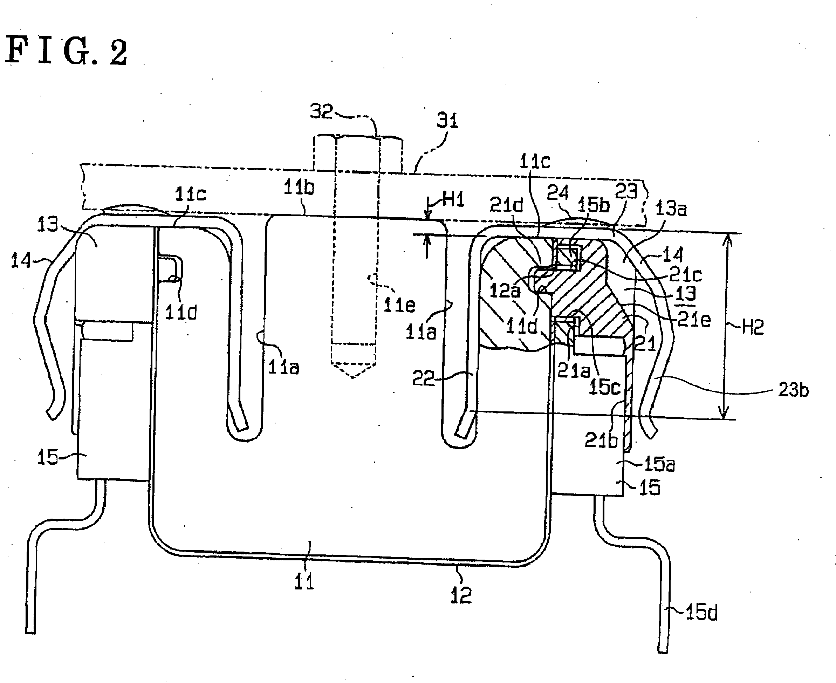

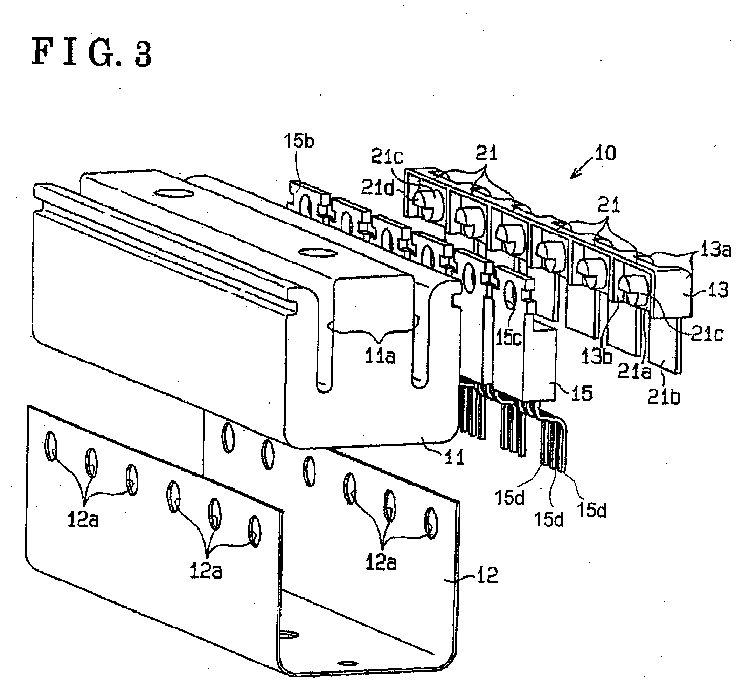

Fig. 1 is a perspective view showing a fixing device 10 applied with the present invention. Fig. 2 is a front view of the fixing device 10. Fig. 2 also shows a cross section of a part of Fig. 1. Fig. 3 is an exploded view of the fixing device 10. As shown in Fig. 3, the fixing device 10 includes a heat sink block 11 (serving as a heat radiation member), an insulator 12, an insulator block 13 (serving as an insulation member), and a clip 14 (serving as a biasing member). A plurality of power transistors 15 (serving as an electronic component) are fixed by means of the fixing device 10.

The fixing device 10 according to the present invention, six power transistors 15 are provided on one side of the insulator 12 and another six power transistors are provided on the other side of the insulator 12, thus twelve power transistors 15 are provided on the fixing device 10. The fixing device 10 includes two insulator blocks 13, one is provided on a first side of the fixing device 10 facing the power transistors 15 and the other is provided on a second side of the fixing device 10 facing the power transistors 15. The fixing device 10 includes six clips 14. Two adjacent power transistors 15 share one clip 14 (i.e., three clips 14 are provided on the first side and the second side of the fixing device 10).

As shown in Fig. 2, the power transistor 15 includes a body portion 15a which molds element portion with resin, and a heat radiation fin 15b made from metal member. The heat radiation fin 15b is exposed from the body portion 15a. Further, three connection terminals 15d are projected from the body portion 15a. A universal component is applied as the power transistor 15.

The heat sink block 11 made of metal having high thermal conductivity is configured approximately in rectangular. The heat sink block 11 includes a pair of engaging grooves 11a, 11a concavely formed penetrating through the heat sink block 11 from a first end (i.e., top of Fig. 1) to a second end (i.e., bottom of Fig. 1). The engaging grooves 11a are arranged approximately symmetrically in width direction penetrating through the heat sink block 11 in longitudinal direction. As shown in Fig. 2, a top surface (i.e., top side of Fig. 1) of a portion sandwiched between the engaging grooves 11a serves as a case attaching surface 11b (serving as an attaching surface). Top surfaces of portions outside of the engaging grooves 11a serve as clip contacting surfaces 11c, 11c. Height of the case attaching surface 11b is determined to be higher than the clip contacting surfaces 11c by a predetermined height HI.

The heat sink block 11 includes a pair of position determining grooves 11d, 11d (serving as a position determining means and as a position determining concave portion) concavely provided on a first side and a second side (i.e., right side and left side of Fig. 1) of the heat sink block 11 respectively. The position determining grooves 11d, 11d are positioned closer to the clip contact surface 11c, and is formed penetrated through a longitudinal direction of the heat sink block 11 from the first end to the second end of the heat sink block 11.

Accordingly, the heat sink block 11 is configured to have a simple cross sectional configuration (i.e., angle section) for manufacturing the heat sink block 11 by means of an extrusion mold. A plurality of (i.e., two) screw holes 11c, 11c which are arranged keeping a predetermined distance from each other in the longitudinal direction are formed on the case attaching surface 11b.

The insulator 12 made from material with high electric insulation is configured to have U-shape in cross section having an opening upward, and to have internal wall surfaces along outer side surface of the heat sink block 11. As shown in Fig. 3, each lateral wall portion of the insulator 12 is formed with six pin insertion bores 12a formed in circle and opening corresponding to each power transistor 15. The pin insertion bores 12a are arranged keeping a predetermined distance from each other in the longitudinal direction. As shown in Fig. 2, the pin insertion bore 12a is configured to have radius slightly larger than height of the position determining groove 11d. The pin insertion bore 12a is arranged so that the center of the pin insertion bore 12a corresponds to a bottom end of the position determining groove 11d when the insulator 12 is attached to the heat sink block 11. In other words, the position determining groove 11d is open to a top half circle of each pin insertion bore 12a in a width direction.

The insulator block 13 determines the position of the power transistor 15 when the insulator 12 is attached to the heat sink block 11. More particularly, the insulator block 13 is made from material having high electric resistivities such as rubber system material and heat resisting synthetic resin, for example, PBT (Poly Buthylene Telephthalete). As shown in Fig. 3, the insulator block 13 includes six attaching portions 21 in total corresponding to each power transistor 15. The attaching portions 21 are divided by means of division walls 13a arranged keeping a predetermined distance from each other in the longitudinal direction.

Internal wall surfaces of each attaching portion 21 include an attaching surface 21a and a contact surface 21b arranged stepwise by a difference in level corresponding to a difference in level of the power transistor 15. A projected wall portion 13b (serving as an accommodation portion) enclosing the heat radiation fin 15b of each power transistor 15 is projected from a peripheral portion of each attaching surface 21a. An accommodation portion of the heat radiation fin 15b is formed by means of the attaching surface 21a and internal wall surfaces of the projected wall potion 13b. A position determining pin 21c having external diameter slightly smaller than an internal diameter of the attaching bore 15c (and pin insertion bore 12a) of the power transistor 15 is provided to be projected from the center of each attaching surface 21a. A top half portion of a tip end of the position determining pin 21c is projected to form a position determining position 21d having a half circle configuration in cross section.

Thus, the position of the power transistor 15 is determined in the longitudinal direction of the insulator block 13 by means of enclosing the heat radiation fin 15b by the projected wall portion 13b of the insulator block 13 and by positioning the position determining pin 21c through the attaching bore 15c. The height of the insulator block 13 is determined (top-bottom direction) relative to the heat sink block 11 along with the power transistor 15 and the insulator 12 by further inserting the position determining pin 21c penetrated through the attaching bore 15c of the power transistor 15 into the pin insertion bore 12a of the insulator 12, and by inserting the position determining portion 21d into the position determining groove 11d. In this state, shakiness of the power transistor 15 is restrained by contact of the contact surface 21b of the attaching portion 21 to a facing end surface of the power transistor 15 (i.e., body portion 15a). In this case, a slight clearance is provided between the attaching surface 21a of the attaching portion 21 and the facing end surface of the power transistor 15 (i.e., heat radiation fin 15b) corresponding to the attaching surface 21a to absorb the influence of the manufacturing dispersion. By the contact of the tip end surface of the projected wall portion 13b to the insulator 12, the heat radiation fin 15b made from metal member is approximately wrapped with insulation member to prevent the short circuit.

As shown in Fig. 2, a first side (i.e., top of Fig. 2) of outside wall surfaces sandwiched between adjacent division wall portions 13a include inclination surfaces 21e respectively inclined downward to project outward. The inclination surfaces 21e guide to assemble the clip 14 to be easily fixed to the heat sink block 11 of the insulator block 13.

The clip 14 is, for example, made from metal member such as stainless metal member. As shown in Fig. 2, the clip 14 includes a first spring portion 22 and a second spring portion 23 configured by being bent from the first spring portion 22 so that the clip 14 includes U-shape configuration in cross section. The second spring portion 23 includes a pair of spring pieces 23a, 23a (shown in Fig. 1) formed by dividing a tip end of the second spring portion 23 corresponding to each power transistor 15. A tip end of each spring piece 23a is further divided to form branches 23b, 23b (serving as tip end forked into two portions),

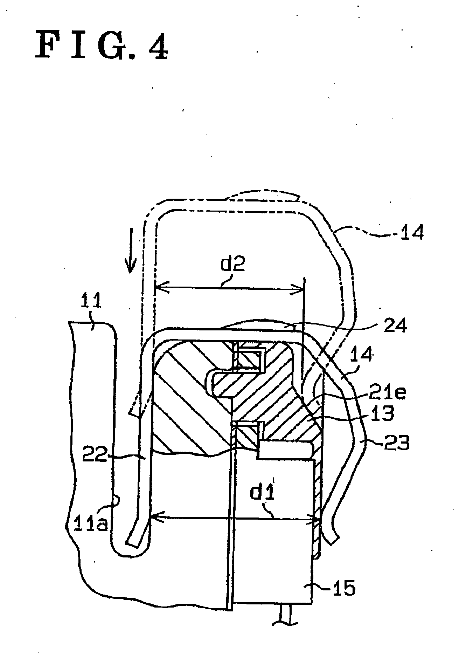

The clip 14 clips and holds the power transistor 15 by guiding the first spring portion 22 and the second spring portion 23 (i.e., spring piece 23a) along the engaging groove 11a and the outside surface of the insulator block 13 to contact the clip contact surface 11c to be attached when the position of the power transistor 15 is determined between the insulator 12 and the insulator block 13 assembled to the heat sink block 11. In other words, as shown in Fig. 4, a distance d1 between the first spring 22 and the second spring 23 when the clip 14 is attached is determined to be larger than a distance d2 when the clip 14 is not attached. When the clip 14 is attached, the power transistor 15 is clipped and held by means of the biasing force of the clip 14, in other words, the force to restore from the distance d1 to the distance d2. The position of the clip 14 is determined in the longitudinal direction relative to the insulator block 13 by positioning each spring piece 23a between adjacent divided wall portions 13a. Because the branches 23b, 23b are formed at the tip end of the spring piece 23a, partial contact of the spring pieces 23a with the insulator block 13 is prevented.

As shown in Fig. 4, the tip end of the first spring portion 22 is inserted into the engaging groove 11a until the tip end of the second spring portion 23 contacts the inclination surface 21e when attaching the clip 4. By further pushing the clip 14 downward from the aforementioned state, the first spring portion 22 is guided to the engaging groove 11a and the tip end of the second spring portion 23 is guided and pushed to be opened out by means of the inclination surface 21e and is further guided by the integrated outer surface of the insulator block 13.

As shown in Fig. 2, length from the clip contact surface. 11c to a position of the tip end of the first spring portion 22 contacted to the engaging groove 11a, and length from the clip contact surface 11c to a position of the tip end of the second spring portion 23 contacted to the outer surface of the insulator block 13 are determined to have approximately the same predetermined height H2. This is for preventing the cause of unstable attached state due to the generation of the rotational force at the clip 14 because of the unbalanced biasing force generated at the clip 14.

The thickness of the clip 14 is determined within the range of the height HI, and the clip contact surface 11c is determined not to project above a case attaching surface 11b. A spring configured projection 24 (serving as a biasing portion) is formed at each base end portion between adjacent spring pieces 23a of the second spring portion 23. The spring configured projection 24 is determined to project above the case attaching surface 11b. This is for elastically contacting the spring configured projection 24 to a facing end surface of a cover portion 31 when assembling the plane cover portion 31. of a case to the case attaching surface 11b of the heat sink block 11 fixed with the power transistor 15, or the like, and connect the cover portion 31 to the heat sink block 11 by means of a bolt 32 penetrated through the screw bore 11e. Accordingly, the shakiness of the fixing device 10, or the like, relative to the case (i.e., cover portion 31) is restrained when accommodating the fixing device 10 in the case and covering the case. The clip 14 does not directly contact the cover portion 31 except the spring configured projection 24. The case (i.e., cover portion 31) is made from metal member having high thermal conductivity such as aluminum member, and serves as heat radiator for radiating the heat conducted from the heat sink block 11.

According to the embodiment of the present invention, the following effects can be obtained.

According to the embodiment of the present invention, the position of the power. transistor 15 is determined by means of the insulator block 13 at an accommodation portion (i.e., projected wall portion 13b and the attaching surface 21a), and is also determined by means of the position determining groove 11d and the position determining pin 21c relative to the heat sink block 11 sandwiched between the heat sink block 11 and the insulator block 13. By clipping and holding the heat sink block 11 and the insulator block 13 with the clip 14 in the foregoing state, the power transistor 15 is supported. Thus, the position of the power transistor 15 can be more securely determined.

Further, because the power transistor 15 is sandwiched between the heat sink block 11 (i.e., insulator 12) and the insulator block 13, the external portion of the power transistor 15 is covered with the insulating material to avoid the exposition to the outside. Thus, the exposure of the power transistor 15 to the outside is avoided by enclosing the external portion by insulator 12 and the insulator block 13. Accordingly, the short circuit of the power transistor 15 can be restrained.

Further, the heat sink block 11, the power transistor 15, and the insulator, block 13 are unitarily arranged by clipping and holding the heat sink block 11 and the insulator block 13 which sandwich the power transistor 15. Accordingly, the degree of freedom for manufacturing process can be increased, for example, by mounting the assembly on the board after assembling the heat sink block 11, the transistor 15, and the insulator 13, or the like at another process.

According to the embodiment of the present invention, the position of the power transistor 15 can be determined relative to the heat sink block 11 with simple construction including the plural position determining pins 21a and the position determining grooves 11d even if the plural power transistors 15 are provided. More particularly, because the configuration in cross section of the heat sink block 11 assumes simple by corresponding the penetration direction of the engaging groove 11a and the position determining groove 11d, for example, the heat sink block 11 can be manufactured only by extrusion die, which can reduce the manufacturing hours.

According to the embodiment of the present invention, the shakiness between the fixing device 10 (i.e., clip 14) and the case attached contacting the case attaching surface 11b of the heat sink block 11 can be restrained by elastically contacting the spring configured projection 24 of the clip 14 to the case (i.e., cover portion 31). Because the case (i.e., cover portion 31) and the fixing device 10 (i.e., clip 14) do not interfere each other, the heat radiation performance can be ensured without being restrained by the interference between the case and the fixing device 10.

According to the embodiment of the present invention, because the spring pieces 23a are individually formed on the second spring portion 23 for each power transistor 15, even if the power transistors 15, or the like, include the manufacturing dispersion, the transistor 15 can be stably supported.

According to the embodiment of the present invention, by using the both sides of the heat sink block 11 in the width direction, plural power transistors 15 can be fixed with favorable space efficiency,

According to the embodiment of the present invention, the clip 14 is smoothly assembled by being guided and gradually pushed and opened out by means of the inclination surface 21e of the insulator block 13 against the biasing force of the clip 14.

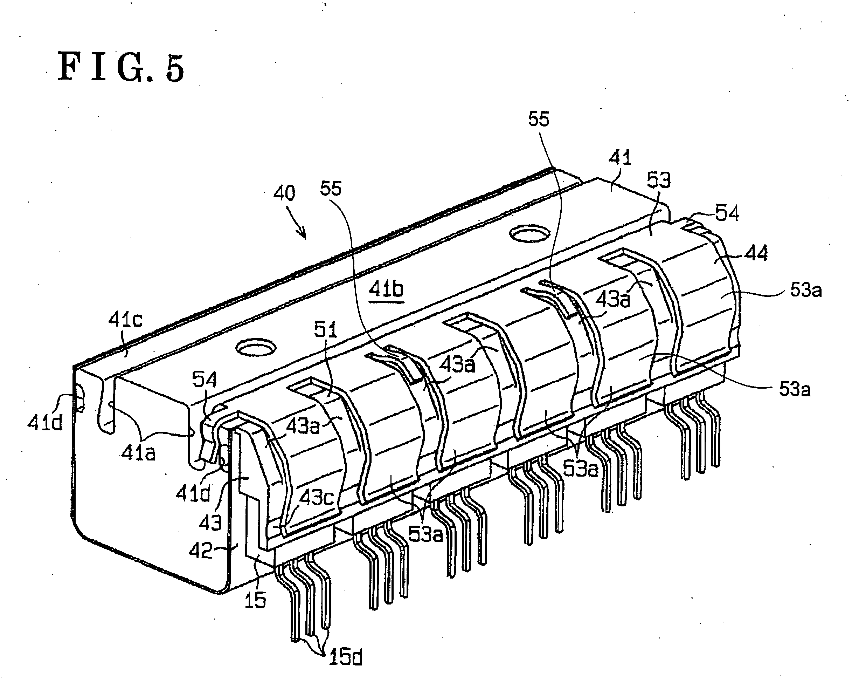

A second embodiment of the present invention will be explained with reference to Figs. 5-6. The construction of some members of the fixing device of the second embodiment is different from the first embodiment. The explanation for the same construction with the first embodiment of the present invention will not be repeated.

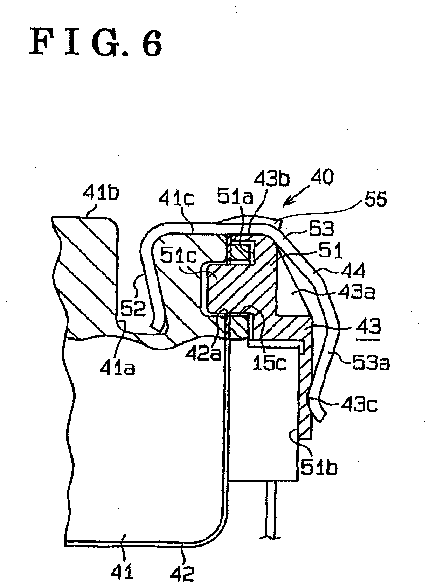

Fig. 5 is a perspective view showing a fixing device 40 applied with the present invention. Fig. 6 is a partial cross-sectional view of Fig. 5. As shown in Fig. 5, the fixing device 40 includes a heat sink block 41 (serving as a heat radiation member), an insulator 42, an insulator block 43 (serving as an insulation member), and a clip 44 (serving as a biasing member). Plural (six) power transistors 15 are fixed by means of the fixing device 40. The fixing device 40 includes two insulator blocks 43 and two clips 44. A first insulator block 43 and a first clip 44 are provided on the transistors 15 positioned at a first side, and a second insulator block 43 and a second clip 44 are provided on the transistors 15 positioned at a second side (i.e., Fig. 5 does not show the insulator block 43 and insulator block 44 provided at the second side).

The heat sink block 41 includes a pair of engaging grooves 41. Top surface (i.e., top side of Fig. 5) of a portion of the heat sink block 41 sandwiched between the engaging grooves 41a serves as a case attaching surface 41b (serving as an attaching surface). Top surfaces of portions of the heat sink block 41 outside of the engaging grooves 41 serve as clip contact surfaces 41c. Depth of the engaging groove 41a is determined to be sallower, approximately one-third of height of the heat sink block 41. This is for ensuring channel dimension for conducting the heat from the power transistor 15 (i.e., heat radiation fin 15b) to the case attaching surface 41b (i.e., case). The engaging grooves 41a are configured to incline downward to be wider towards the power transistor 15 side. In other words, the angle formed by the clip contact surface 41c and the engaging groove 41a assumes an acute angle.

The heat sink block 41 includes a pair of position determining grooves 41d, 41d (serving as a position determining means and as a position determining concave portion) concavely formed penetrated through the heat sink block 41 from a first end to a second end (i.e., from right side to a left side of Fig. 5). The position determining grooves 41d are positioned closer to the clip contact surface 41c. Height of the position determining groove 41d is determined slightly shorter than an external diameter of the attaching bore 15c of the power transistor 15.

As shown in Fig. 6, a pin insertion bore 42a configured in circle and opening corresponding to each power transistor 15 is provided on lateral wall portion of each insulator 42. The pin insertion bore 42a includes a diameter approximately the same with height of the position determining groove 41d. When the insulator 42 is attached to the heat sink block 41, the position determining groove 41d opens in width direction of the circle of the pin insertion bore 42a.

The insulator block 43 is configured based on the configuration of the insulator clock 13, and the position of the power transistor 15 is determined when the insulator 42 is attached to the heat sink block 41. More particularly, the insulator block 43 includes six attaching portions 51 each corresponding to the power transistor 15. The attaching portion 51 is divided by division wall portions 43a arranged keeping a predetermined distance from each other in the longitudinal direction.

Internal wall surface of each attaching portion 51 includes an attaching surface 51a and a contact surface 51b arranged stepwise by a difference in level corresponding to stepped portion of the power transistor 15. A projected wall portion 43b (serving as an accommodation portion) is projected from the peripheral portion of the attaching surface 51a to enclose the heat radiation fin 15b of each power transistor 15. The internal wall surface of the attaching surface 51a and the projected wall portion 43b serve as an accommodation portion. A position determining pin 51c having an external diameter slightly smaller than an internal diameter of the attaching bore 15c of the power transistor 15 is projected from the center of each attaching surface 51a.

Accordingly, the position of the power transistor 15 is determined in the longitudinal direction of the insulator block 43 by enclosing the heat radiation fin 15b with the projected wall portion 43b of the insulator block 43 and by inserting the position determining pin 51c into the attaching bore 15c. The height of the insulator block 43 is determined relative to the heat sink block 41 along with the power transistor 15 and the insulator 42 by further inserting the position determining pin 51c penetrated through the attaching bore 15c of the power transistor 15 into the position determining groove 41d and the pin insertion bore 42a of the insulator 42. The contact surface 51b is integrally formed in the longitudinal direction of the insulator block 43. With this construction, because the contact surface 51b contacts the corresponding facing end surface of the power transistor 15 (body portion 15a), the shakiness of the power transistor 15 is restrained. In this case, the contact surface 51b is not necessarily integrally formed in the longitudinal direction of the insulator block 43 and may be divided by the power transistor 15 to correspond to the height and the external configuration of the power transistor 15.

Further, a position determining groove 43c (serving as a groove portion) extended in the longitudinal direction is formed on external surface of the insulator block 43. The position determining groove 43c is used for determining the position of the clip 44.

As shown in Fig. 6, the clip 44 includes a first spring portion 52 and a second spring portion 53 formed by being bent from the first spring portion 52 to make an acute angle so that the clip 44 is formed in U-shape in cross section. The second spring portion 53 includes six spring pieces 53a configured by dividing tip end side of the second spring portion 53 corresponding to each power transistor 15 (shown in Fig. 5).

The clip 44 clips and holds the power transistor 15, or the like, by attaching the first spring portion 52 and the second spring portion 53 (i.e., spring pieces 53a) along the external surface of the engaging groove 41a and the insulator block 43 to contact the clip contact surface 41c when the position of the power transistor 15 is determined between the insulator 42 and the insulator block 43 attached on the heat sink block 41. More particularly, according to the second embodiment of the present invention, dislocation is prevented by determining the angle formed by the clip contact surface 41c and the engaging groove 41a to be at an acute angle.

Position of the clip 44 is determined in the longitudinal direction relative to the insulator block 43 by being arranged between the division wall portions 43a adjacent to the spring pieces 53a. Position of a tip end of each spring pieces 53a is determined by being fitted into the position determining groove 43c. Further, the clip 44 includes a pair of spring projected portions 54 (serving as a restriction portion) configured integrally from both sides of the second spring portion 53 extended and bent downward at a first side and a second side. Position of the clip 44 is also determined in the longitudinal direction by clipping and holding the heat sink block 41 with the spring projected portions 54.

According to the second embodiment of the present invention, the following effects can be obtained in addition to the effects of the first embodiment.

According to the embodiment of the present invention, the position of the clip 44 is determined relative to the heat sink block 41 by clipping and holding the heat sink block 41 by the spring projected portions 54 in the different direction from the clipping direction of the heat sink block 41 and the insulator block 43. In other words, move of the clip 44 relative to the heat sink block 41 is restricted from the different direction of the clipping direction by the spring projected portion 54, and the position of the clip 44 is determined relative to the heat sink block 41 in this different direction. Accordingly, the discrepancy and dislocation of the clip 44 in the clipping and holding direction of the spring projected portion 54 can be restrained.

According to the embodiment of the present invention, by determining the position of the second spring portion 53 (i.e., spring piece 53a) by the position determining groove 43c of the insulator block 43, for example, the discrepancy and dislocation of the second spring portion 53 can be restrained.

According to the embodiment of the present invention, because the engaging groove 41a is concavely formed and inclined downwards towards the power transistor 15 side, the clip 44 (i.e., first spring portion 52) elastically contacting the included engaging groove 41a inclines in the clipping direction. Accordingly, the dislocation of the clip 44 is prevented and the dislocation of the clip 44 is restrained.

According to the embodiment of the present invention, the heat radiation efficiency can be improved because the channel dimension for conducting the heat from the power transistor 15 to the case attaching surface 41b (case) is ensured.

Embodiments of the present invention may be varied in the following manner.

In the second embodiment of the present invention, a tip end of each spring piece 53a may be forked into two portions. In the first and the second embodiments of the present invention, a tip end of each spring piece 23a, 53a may be forked into three portions. In this case, height of forked ends of the spring piece 23a, 53a elastically contacting the insulator block 13, 43 are not necessarily identical and may be varied. For example, in case the tip end of the spring piece 23a, 53a is forked into three portion, more stable support which is not influenced by the manufacturing dispersion is achieved by determining height of the tip end elastically contacting the insulator block 13, 43 and arranged in the center relative to both wings at different heights and by supporting at three points.

According to the second embodiment of the present invention, the heat sink block 41 is clipped and held from the direction different from the clipping direction of the heat sink block 41 and the insulator block 43 by means of the spring projected portion 54 of the clip 44. In the second embodiment of the present invention, for example, by forming a restriction portion which serves in place of the spring projected portion 54 on the clip 44, the move of the clip 44 relative to the heat sink block 41 may be restricted in the direction different from the clipping direction of the heat sink block 41 and the insulator block 43.

According to the first and the second embodiments of the present invention, the height of the power transistor 15 is determined by means of the position determining pin 21c, 51c of the insulator block 13, 43, and the position determining groove 11d, 41d, of the heat sink block 11, 41. In the first and second embodiments of the present invention, a position determining concave portion may be formed on the heat sink block 11, 41 facing the position determining pin 21c, 51c. Further, a position determining pin penetrated through the attaching bore 15c of the power transistor 15 may be provided on the heat sink block 11, 41, and a position determining concave portion may be formed on the insulator block 13, 43. In this case, the height of the power transistor 15 can be determined with a simple construction including the position determining pin and the concave portion.

Although the power transistor 15 is applied as an electronic component, it is not limited to the power transistor and other electronic components having the heat radiation can be applied.

The number of the fixed electronic components is not limited to the specific number.

## Claims

1. A fixing device (10, 40) suitable for fixing an electronic component (15) comprising:
a heat radiation member (11, 41) having a top surface, said top surface including a central attaching surface (11b, 41b) and a lateral contacting surface (11c, 41c) separated by an engaging groove (11a, 41a), the central attaching surface (11b, 41b) being higher than the lateral contacting surface (11c, 41c);
an insulation member (13, 43) having an accommodation portion (13b, 43b) for the electronic component, the electronic component to be sandwiched between the heat radiation member (11, 41) and said insulation member (13, 43);
a position determining means for determining a position of the electronic component (15) relative to the heat radiation member (11, 41), said position determining means including a position determining pin (21c, 51c) convexly provided at one of the heat radiation member (11, 41) and the insulation member (13, 43) and configured to penetrate through a part of the electronic component (15), said position determining means further including a position determining concave portion (11d, 41d) concavely provided at the other of the heat radiation member (11, 41) and the insulation member (13, 43) and configured to be fitted with the position determining pin (21c, 51c);
a biasing member (14, 44) suitable for holding the heat radiation member (11, 41) and the insulation member (13, 43) along with the electronic component (15) by elastically contacting a first end (22, 52) and a second end (23, 53) thereof with the engaging groove (11a, 41a) and the insulation member (13, 43), respectively and by contacting a portion of said biasing member (14, 44) situated between said first end and said second end with the lateral contacting surface (11c, 41c) of the heat radiation member (11, 41); wherein
the central attaching surface (11b, 41b) of the heat radiation member (11, 41) is configured to be attached with an external heat radiation member (31); and wherein the biasing member (14, 44)
includes a biasing portion (24, 55) which projects above the central attaching surface (11b, 41b) when the electronic component (15) is fixed in its final position by said biasing member (14, 44), said biasing portion being configured to elastically contact said external heat radiation member (31).

2. A fixing member (40) according to Claim 1, wherein the biasing member (44) includes a pair of spring projected portions (54) formed integrally at two opposite sides of the biasing member, said spring projected portions extending longitudinally parallel to the engaging groove and vertically in the same direction as the first and second ends, said pair of spring projected portions serving as a restriction portion for restricting longitudinal movement of the biasing member (44) relative to the heat radiation member (41).

3. A fixing member (40) according to Claim 1, wherein the insulation member (43) includes a groove portion (43c) for determining a position of the second end of the biasing member (44).

4. A fixing member (40) according to Claim 1, wherein the engaging groove (41a) is concavely formed and inclined downwards towards the electronic component (15).

5. A fixing member (40) according to Claim 4, wherein the engaging groove (41a) depth corresponds to one-third of the height of the heat radiation member (41).

6. A fixing member (10) according to Claim 1, wherein the second end (23) of the biasing member (14) includes a pair of spring pieces (23a, 23a), the tip end of each of said spring pieces being forked into two branches (23b, 23b).

7. A fixing member (10, 40) according to Claim 1, further comprising:
an insulator (12, 42) provided between the heat radiation member (11, 41) and the electronic component (15).

8. A fixing member (10, 40) according to Claim 1, wherein two engaging grooves (11a, 41a) provided at the heat radiation member (11, 41) are arranged in parallel to one another.

## Patentansprüche

1. Befestigungsvorrichtung (10, 40), die geeignet ist, ein elektronisches Bauelement (15) zu befestigen, mit:
einem Wärmeabstrahlungsbauteil (11, 41), das eine obere Fläche hat, wobei die obere Fläche eine zentrale Anschlussfläche (11b, 41b) und eine seitliche Kontaktfläche (11c, 41c) hat, die durch eine Eingriffsnut (11a, 41a) getrennt ist, wobei die zentrale Anschlussfläche (11b, 41b) höher ist als die seitliche Kontaktfläche (11c, 41c);
einem Isolierbauteil (13, 43), das einen Aufnahmeabschnitt (13b, 43b) für das elektronische Bauelement hat, wobei das elektronische Bauelement zwischen dem Wärmeabstrahlungsbauteil (11, 41) und dem Isolierbauteil (13, 43) anzuordnen ist;
einem Positionsfestlegungsmittel zum Festlegen einer Position des elektronischen Bauelements (15) in Bezug auf das Wärmeabstrahlungsbauteil (11, 41), wobei das Positionsfestlegungsmittel einen Positionsfestlegungszapfen (21c, 51c) hat, der vorstehend konvex an einem von dem Wärmeabstrahlungsbauteil (11, 41) und dem Isolierbauteil (13, 43) bereitgestellt und konfiguriert ist, einen Teil des elektronischen Bauelements (15) zu durchdringen, wobei das Positionsfestlegungsmittel ferner einen Positionsfestlegungs-Konkavabschnitt (11d, 41d) hat, der konkav an dem anderen von dem Wärmeabstrahlungsbauteil (11, 41) und dem Isolierbauteil (13, 43) bereitgestellt und konfiguriert ist, an den Positionsfestlegungszapfen gefügt zu sein;
einem Vorspannbauteil (14, 44), das zum Halten des Wärmeabstrahlungsbauteils (11, 41) und des Isolierbauteils (13, 43) zusammen mit dem elektronischen Bauelement (15) geeignet ist, indem ein erstes Ende (22, 52) beziehungsweise ein zweites Ende (23, 53) davon die Eingriffsnut (11a, 41a) beziehungsweise das Isolierbauteil (13, 43) elastisch berühren, und indem ein Abschnitt des Vorspannbauteils (14, 44), der sich zwischen dem ersten Ende und dem zweiten Ende befindet, die seitliche Kontaktfläche (11c, 41c) des Wärmeabstrahlungsbauteils (11, 41) berührt; wobei
die zentrale Anschlussfläche (11b, 41b) des Wärmeabstrahlungsbauteils (11, 41) konfiguriert ist, an einem externen Wärmeabstrahlungsbauteil (31) angeschlossen zu sein; und wobei
das Vorspannbauteil (14, 44) einen Vorspannabschnitt (24, 55) hat, der über die zentrale Anbringungsfläche (11b, 41b) herausragt, wenn das elektronische Bauelement (15) durch das Vorspannbauteil (14, 44) in seiner Endposition befestigt ist, wobei der Vorspannabschnitt konfiguriert ist, das externe Wärmeabstrahlungsbauteil (31) elastisch zu berühren.

2. Befestigungsbauteil (40) nach Anspruch 1, wobei das Vorspannbauteil (44) ein Paar Federvorsprungsabschnitte (54) hat, die einstückig an zwei entgegengesetzten Seiten des Vorspannbauteils ausgebildet sind, wobei sich die Federvorsprungsabschnitte in Längsrichtung parallel zu der Eingriffsnut und vertikal in der gleichen Richtung wie das erste und zweite Enden erstrecken, wobei das Paar Federvorsprungsabschnitte als Begrenzungsabschnitt zum Begrenzen der Längsbewegung des Vorspannbauteils (44) in Bezug auf das Wärmeabstrahlungsbauteil (41) dient.

3. Befestigungsbauteil (40) nach Anspruch 1, wobei das Isolierbauteil (43) einen Nutabschnitt (43c) zum Festlegen einer Position des zweiten Endes des Vorspannbauteils (44) hat.

4. Befestigungsbauteil (40) nach Anspruch 1, wobei die Eingriffsnut (41a) konkav ausgebildet ist und nach unten in Richtung des elektronischen Bauelements (15) geneigt ist.

5. Befestigungsbauteil (40) nach Anspruch 4, wobei die Tiefe der Eingriffsnut (41a) einem Drittel der Höhe des Wärmeabstrahlungsbauteils (41) entspricht.

6. Befestigungsbauteil (10) nach Anspruch 1, wobei das zweite Ende (23) des Vorspannbauteils (14) ein Paar Federstücke (23a, 23a) hat, wobei das spitze Ende von jedem der Federstücke in zwei Abzweige (23b, 23b) gespalten ist.

7. Befestigungsbauteil (10, 40) nach Anspruch 1, das ferner einen Isolator (12, 42) aufweist, der zwischen dem Wärmeabstrahlungsbauteil (11, 41) und dem elektronischen Bauteil (15) bereitgestellt ist.

8. Befestigungsbauteil (10, 40) nach Anspruch 1, wobei zwei Eingriffsnuten (11a, 41a), die an dem Wärmeabstrahlungsbauteil (11, 41) bereitgestellt sind, parallel zueinander angeordnet sind.

## Revendications

1. Dispositif de fixation (10, 40) approprié pour fixer un composant électronique (15) comprenant :
un élément de rayonnement de chaleur (11, 41) ayant une surface supérieure, ladite surface supérieure comprenant une surface de fixation centrale (11b, 41b) et une surface de contact latérale (11c, 41c) séparée par une rainure de mise en prise (11a, 41a), la partie de fixation centrale (11b, 41b) étant supérieure à la surface de contact latérale (11c, 41c) ;
un élément d'isolation (13, 43) ayant une partie de logement (13b, 43b) pour le composant électronique, le composant électronique étant destiné à être pris en sandwich entre l'élément de rayonnement de chaleur (11, 41) et ledit élément d'isolation (13, 43) ;
un moyen de détermination de position pour déterminer une position du composant électronique (15) par rapport à l'élément de rayonnement de chaleur (11, 41), ledit moyen de détermination de position comprenant une broche de détermination de position (21c, 51c) prévue, de manière convexe, au niveau de l'un parmi l'élément de rayonnement de chaleur (11, 41) et l'élément d'isolation (13, 43) et configurée pour pénétrer à travers une partie du composant électronique (15), ledit moyen de détermination de position comprenant en outre une partie concave de détermination de position (11d, 41d) prévue, de manière concave, au niveau de l'autre parmi l'élément de rayonnement de chaleur (11, 41) et l'élément d'isolation (13, 43) et configurée pour être montée avec la broche de détermination de position (21c, 51c) ;
un élément de sollicitation (14, 44) approprié pour maintenir l'élément de rayonnement de chaleur (11, 41) et l'élément d'isolation (13, 43) conjointement avec le composant électronique (15) en mettant en contact élastique sa première extrémité (22, 52) et sa seconde extrémité (23, 53) avec la rainure de mise en prise (11a, 41a) et l'élément d'isolation (13, 43) respectivement et en mettant en contact une partie dudit élément de sollicitation (14, 44) situé entre ladite première extrémité et ladite seconde extrémité avec la surface de contact latérale (11c, 41c) de l'élément de rayonnement de chaleur (11, 41) ; dans lequel :
la surface de fixation centrale (11b, 41b) de l'élément de rayonnement de chaleur (11, 41) est configurée pour être fixée avec un élément de rayonnement de chaleur externe (31) ; et dans lequel l'élément de sollicitation (14, 44) comprend une partie de sollicitation (24, 55) qui fait saillie au-dessus de la surface de fixation centrale (11b, 41b) lorsque le composant électronique (15) est fixé dans sa position définitive par ledit élément de sollicitation (14, 44),
ladite partie de sollicitation étant configurée pour être élastiquement en contact avec ledit élément de rayonnement de chaleur externe (31).

2. Elément de fixation (40) selon la revendication 1, dans lequel l'élément de sollicitation (44) comprend une paire de parties en saillie de ressort (54) formées de manière solidaire au niveau des deux côtés opposés de l'élément de sollicitation, lesdites parties en saillie de ressort s'étendant longitudinalement parallèlement à la rainure de mise en prise et verticalement dans la même direction que les première et seconde extrémités, ladite paire de parties en saillie de ressort servant de partie de restriction pour limiter un mouvement longitudinal de l'élément de sollicitation (44) par rapport à l'élément de rayonnement de chaleur (41).

3. Elément de fixation (40) selon la revendication 1, dans lequel l'élément d'isolation (43) comprend une partie de rainure (43c) pour déterminer une position de la seconde extrémité de l'élément de sollicitation (44).

4. Elément de fixation (40) selon la revendication 1, dans lequel la rainure de mise en prise (41a) est formée de manière concave et inclinée vers le bas vers le composant électronique (15).

5. Elément de fixation (40) selon la revendication 4, dans lequel la profondeur de la rainure de mise en prise (41a) correspond à un tiers de la hauteur de l'élément de rayonnement de chaleur (41).

6. Elément de fixation (10) selon la revendication 1, dans lequel la seconde extrémité (23) de l'élément de sollicitation (14) comprend une paire de pièces de ressort (23a, 23a), l'extrémité de pointe de chacune desdites pièces de ressort étant fourchue en deux branches (23b, 23b).

7. Elément de fixation (10, 40) selon la revendication 1, comprenant en outre :
un isolant (12, 42) prévu entre l'élément de rayonnement de chaleur (11, 41) et le composant électronique (15).

8. Elément de fixation (10, 40) selon la revendication 1, dans lequel deux rainures de mise en prise (11a, 41a) prévues au niveau de l'élément de rayonnement de chaleur (11, 41) sont agencées parallèlement entre elles.
